# EUROPÄISCHE PATENTANMELDUNG

(11) **EP 4 160 677 A1**
(43) Veröffentlichungstag der Anmeldung: **05.04.2023**
(21) Anmeldenummer: 21200047.5
(22) Anmeldetag: 30.09.2021
(51) Int. Cl.: H01L 23/64, H01L 25/07, H01L 23/498, H01L 23/00

(54) **HALBLEITERANORDNUNG MIT MINDESTENS ZWEI HALBLEITERELEMENTEN**

(71) Anmelder: Siemens Aktiengesellschaft, 80333 München (DE)
(72) Erfinder: Endres, Michael, 96110 Schesslitz (DE); Gospos, Robert, 91054 Buckenhof (DE); Kürten, Bernd, 90587 Obermichelbach (DE); Zeyß, Felix, 93059 Regensburg (DE)
(74) Vertreter: Siemens Patent Attorneys

(57) **Zusammenfassung**

Die Erfindung betrifft eine Halbleiteranordnung (2) mit mindestens, insbesondere parallel geschalteten, Halbleiterelementen (4), einem isolierenden Substrat (6) und einem Anschlusselement (44), wobei das Substrat (6) elektrisch voneinander isolierte Leiterbahnen (10, 12, 14) aufweist, wobei die Halbleiterelemente (4), insbesondere stoffschlüssig, mit einer ersten Leiterbahn (10) des Substrats (6) verbunden sind und auf einer dem Substrat (6) abgewandten Seite jeweils zumindest eine Kontaktfläche (26) aufweisen, wobei jeweils zumindest eine Kontaktfläche (26) der Halbleiterelemente (4) über erste Bondverbindungsmittel (28) mit einer zweiten Leiterbahn (12) des Substrats (6) verbunden ist, wobei die zweite Leiterbahn (12) über elektrisch leitfähige Verbindungsmittel (32, 32a, 32b, 32c, 32d) mit einer dritten Leiterbahn (14) des Substrats (6) verbunden ist, wobei die dritte Leiterbahn (14) mit dem Anschlusselement (44) verbunden ist, wobei von den Halbleiterelementen (4) zum Anschlusselement (44) jeweils ein Strompfad mit einer Strompfad-Impedanz ausgebildet ist. Um eine höhere Lebensdauer zu erreichen und Kosten zu sparen, wird vorgeschlagen, dass die elektrisch leitfähigen Verbindungsmittel (32, 32a, 32b, 32c, 32d) derartig dimensioniert und/oder angeordnet sind, dass die Strompfad-Impedanzen der jeweiligen Strompfade im Wesentlichen ausgeglichen sind.

## Beschreibung

Die Erfindung betrifft eine Halbleiteranordnung mit mindestens zwei, insbesondere parallel geschalteten, Halbleiterelementen, einem isolierenden Substrat und einem Anschlusselement.

Ferner betrifft die Erfindung ein Halbleitermodul mit mindestens einer derartigen Halbleiteranordnung.

Darüber hinaus betrifft die Erfindung einen Stromrichter mit mindestens einer derartigen Halbleiteranordnung.

Überdies betrifft die Erfindung ein Verfahren zur Herstellung einer Halbleiteranordnung mit mindestens zwei, insbesondere parallel geschalteten, Halbleiterelementen, einem isolierenden Substrat und einem Anschlusselement.

Eine derartige Halbleiteranordnung kommt in der Regel in einem Halbleitermodul zum Einsatz, welches in einem Stromrichter verbaut ist. Unter einem Stromrichter ist beispielsweise ein Gleichrichter, ein Wechselrichter, ein Umrichter oder ein Gleichspannungswandler zu verstehen. Die im Halbleitermodul zum Einsatz kommenden Halbleiterelemente sind unter anderem Transistoren, Triacs, Thyristoren oder Dioden. Transistoren sind beispielsweise als Insulated-Gate-Bipolar-Transistoren (IGBTs), Feldeffekttransistoren oder Bipolar-transistoren ausgeführt. In derartigen Halbleitermodulen können mehrere auf einem Substrat angeordnete Halbleiterelemente, insbesondere Halbleiterschaltelemente, zum Einsatz kommen, wobei ein geometrischer Verlauf eines Laststroms durch die jeweiligen Halbleiterelemente von einer Vielzahl von Faktoren abhängt, welche die Anordnung der Halbleiterelemente sowie deren Kontaktierung auf dem Substrat beinhalten.

Ein Stromfluss durch parallel geschaltete Halbleiterelemente kann zumindest leicht unterschiedlich sein, sodass sich eine Verlustleistung nicht gleichmäßig auf die Halbleiterelemente aufteilt, wodurch sogenannte Hotspots ausgebildet werden. Dies sorgt für eine Verringerung einer Lebensdauer des Gesamtaufbaus, da die Lebensdauer von der maximal auftretenden Halbleitertemperatur begrenzt wird. Ferner tritt ein ähnlicher Effekt zutage, wenn in einer Halbleiteranordnung mehrere Halbleiterelemente zu einer Funktionsschaltung verschaltet sind. Während des Betriebes sind zu unterschiedlichen Zeitpunkten verschiedene Halbleiter mit dem Laststrom durchflossen. Da diese sich räumlich voneinander getrennt befinden, verändert sich im zeitlichen Ablauf auch der geometrische Weg des Stromflusses. Durch unterschiedliche Strompfade können sich für die unterschiedlichen Schaltzustände infolge unterschiedlicher parasitärer Impedanzen, insbesondere parasitärer Widerstände und/oder parasitärer Induktivitäten, ergeben, woraus sich ein ungleichmäßiges Schaltverhalten der verschiedenen Halbleiter ergibt. Darüber hinaus kann unter anderem eine Messeinrichtung mit einem ohmschen Widerstand zur Erfassung eines Laststroms zu einer, insbesondere von einem Schaltzustand der Halbleiterelemente abhängigen, Beeinflussung der Messung und/oder des Laststroms selbst führen.

Die Offenlegungsschrift DE 10 2012 220 127 A1 beschreibt eine Halbleiterschaltvorrichtung mit einem Gehäuse und einem Halbleiterschaltelement, dass in dem Gehäuse bereitgestellt ist und das eine Kollektorelektrode und eine Emitterelektrode aufweist. Ein Hauptkollektoranschluss und ein Hauptemitteranschluss widerspiegeln einen Spannungsabfall, der während des Anlegens eines Stroms durch eine erdfreie Komponente in dem Gehäuse erzeugt wird. Ein zweiter Kollektoranschluss und ein zweiter Emitteranschluss detektieren eine Spannung zwischen der Kollektorelektrode und der Emitterelektrode, ohne den Spannungsabfall zu widerspiegeln. Ein dritter Emitteranschluss ist in der Nähe des zweiten Emitteranschlusses angeordnet und detektiert den zwischen dem Hauptemitteranschluss und dem zweiten Emitteranschluss erzeugten Spannungsabfall.

Vor diesem Hintergrund liegt der Erfindung die Aufgabe zugrunde, eine Halbleiteranordnung anzugeben, welche, im Vergleich zum Stand der Technik, eine höhere Lebensdauer erreicht und kostengünstiger ist.

Die Aufgabe wird erfindungsgemäß gelöst durch eine Halbleiteranordnung mit mindestens zwei, insbesondere parallel geschalteten, Halbleiterelementen, einem isolierenden Substrat und einem Anschlusselement, wobei das Substrat elektrisch voneinander isolierte Leiterbahnen aufweist, wobei die Halbleiterelemente, insbesondere stoffschlüssig, mit einer ersten Leiterbahn des Substrats verbunden sind und auf einer dem Substrat abgewandten Seite jeweils zumindest eine Kontaktfläche aufweisen, wobei jeweils zumindest eine Kontaktfläche der Halbleiterelemente über erste Bondverbindungsmittel mit einer zweiten Leiterbahn des Substrats verbunden ist, wobei die zweite Leiterbahn über elektrisch leitfähige Verbindungsmittel mit einer dritten Leiterbahn des Substrats verbunden ist, wobei die dritte Leiterbahn mit dem Anschlusselement verbunden ist, wobei von den Halbleiterelementen zum Anschlusselement jeweils ein Strompfad mit einer Strompfad-Impedanz ausgebildet ist, wobei die elektrisch leitfähigen Verbindungsmittel derartig dimensioniert und/oder angeordnet sind, dass die Strompfad-Impedanzen der jeweiligen Strompfade im Wesentlichen ausgeglichen sind.

Ferner wird die Aufgabe erfindungsgemäß gelöst durch ein Halbleitermodul mit mindestens einer derartigen Halbleiteranordnung.

Überdies wird die Aufgabe erfindungsgemäß gelöst durch einen Stromrichter mit mindestens einer derartigen Halbleiteranordnung.

Darüber hinaus wird die Aufgabe erfindungsgemäß gelöst durch ein Verfahren zur Herstellung einer Halbleiteranordnung mit mindestens zwei, insbesondere parallel geschalteten, Halbleiterelementen, einem isolierenden Substrat und einem Anschlusselement, wobei das Substrat elektrisch voneinander isolierte Leiterbahnen aufweist, wobei die Halbleiterelemente, insbesondere stoffschlüssig, mit einer ersten Leiterbahn des Substrats verbunden werden und auf einer dem Substrat abgewandten Seite jeweils zumindest eine Kontaktfläche aufweisen, wobei jeweils zumindest eine Kontaktfläche der Halbleiterelemente über erste Bondverbindungsmittel mit einer zweiten Leiterbahn des Substrats verbunden wird, wobei die zweite Leiterbahn über elektrisch leitfähige Verbindungsmittel mit einer dritten Leiterbahn des Substrats verbunden wird, wobei die dritte Leiterbahn mit dem Anschlusselement verbunden wird, wobei von den Halbleiterelementen zum Anschlusselement jeweils ein Strompfad mit einer Strompfad-Impedanz ausgebildet ist, wobei die elektrisch leitfähigen Verbindungsmittel derartig dimensioniert und/oder angeordnet werden, dass die Strompfad-Impedanzen der jeweiligen Strompfade im Wesentlichen ausgeglichen sind.

Die in Bezug auf die Halbleiteranordnung nachstehend angeführten Vorteile und bevorzugten Ausgestaltungen lassen sich sinngemäß auf das Halbleitermodul, den Stromrichter und das Verfahren übertragen.

Der Erfindung liegt die Überlegung zugrunde, die Lebensdauer einer Halbleiteranordnung zu erhöhen, indem Strompfade von mindestens zwei Halbleiterelementen der Halbleiteranordnung durch Ausgleichen von Strompfad-Impedanzen mittels Dimensionierung und/oder Anordnung elektrisch leitfähiger Verbindungsmittel symmetriert werden. Da die Lebensdauer der Halbleiterelemente von einer maximal auftretenden Halbleitertemperatur begrenzt wird, wird durch eine derartige Symmetrierung der jeweiligen Strompfad-Impedanzen eine gleichmäßige Erwärmung der Halbleiterelemente erreicht. Eine derartige Halbleiteranordnung kann unter anderem in einem Halbleitermodul angeordnet oder direkt mit einem Kühlkörper eines Stromrichters verbunden sein. Die mindestens zwei Halbleiterelemente sind beispielsweise als Transistoren, insbesondere als Insulated-Gate-Bipolar-Transistoren (IGBTs), ausgeführt und weisen optional jeweils eine antiparallele Diode auf. Alternativ können die Halbleiterelemente unter anderem als weitere Transistortypen, wie Feldeffekttransistoren oder Bipolartransistoren, ausgeführt sein. Ferner können die Halbleiterelemente parallel geschaltet und/oder zu einer Funktionsschaltung, beispielsweise zu einer Halbbrücke, verschaltet sein.

Die Halbleiteranordnung umfasst darüber hinaus ein isolierendes Substrat und ein Anschlusselement, wobei das Substrat elektrisch voneinander isolierte Leiterbahnen aufweist. Das Substrat kann z.B. als DCB-Substrat (engl. direct copper bonded substrate) ausgeführt sein. Die Halbleiterelemente sind, insbesondere stoffschlüssig, mit einer ersten Leiterbahn des Substrats verbunden. Ferner weisen die Halbleiterelemente auf einer dem Substrat abgewandten Seite jeweils zumindest eine Kontaktfläche auf. Derartige Kontaktflächen sind unter anderem metallische Pads, welche zur Kontaktierung von Bondverbindungsmitteln geeignet sind. Beispielsweise sind die Kontaktflächen als Emitter- oder Source-Pads ausgeführt. Jeweils eine Kontaktfläche der Halbleiterelemente ist über ein erstes Bondverbindungsmittel mit einer zweiten Leiterbahn des Substrats verbunden. Das erste Bondverbindungsmittel umfasst beispielsweise Bonddrähte und/oder Bondbänder, welche im Wesentlichen parallel zueinander angeordnet sind. Die zweite Leiterbahn wird über elektrisch leitfähige Verbindungsmittel mit einer dritten Leiterbahn des Substrats verbunden. Die elektrisch leitfähigen Verbindungsmitteln können unter anderem Widerstandselemente und/oder Induktivitäten aufweisen, welche beispielsweise stoffschlüssig mit der zweiten Leiterbahn und dritten Leiterbahn verbunden werden. Die dritte Leiterbahn ist, beispielsweise über Bondverbindungsmittel, mit dem Anschlusselement verbunden. Das Anschlusselement ist z.B. für eine Verbindung mit einer Stromschiene konfiguriert. Die Halbleiterelementen bilden zum Anschlusselement jeweils einen Strompfad mit einer Strompfad-Impedanz aus. Die Strompfad-Impedanzen können sich unter anderem aufgrund unterschiedlicher Widerstände der Halbleiterelemente, Widerstände von Bondverbindungsmitteln im Strompfad, Leitungslängen und/oder Übergangswiderstände voneinander unterscheiden. Die elektrisch leitfähigen Verbindungsmittel, welche die zweite Leiterbahn mit der dritten Leiterbahn verbinden, werden derartig dimensioniert und/oder angeordnet, dass die Strompfad-Impedanzen der jeweiligen Strompfade im Wesentlichen ausgeglichen sind. Beispielsweise wird ein elektrischer Widerstand von als Widerstandselementen ausgeführten elektrisch leitfähigen Verbindungsmitteln angepasst, sodass eine Symmetrierung der jeweiligen Strompfad-Impedanzen stattfindet. Ein asymmetrischer Anschluss des Anschlusselements kann auf diese Weise ebenfalls ausgeglichen werden. Neben einer Erhöhung der Lebensdauer werden darüber hinaus Kosten gespart, da bei einer gleichmäßigen, insbesondere thermischen, Auslastung kleinere und damit günstigere Halbleiterelemente verwendbar sind. Durch die Verwendung kleinerer Halbleiterelemente sind diese flexibler auf dem Substrat positionierbar, sodass eine verbesserte Entwärmung stattfinden kann, was zusätzlich die Lebensdauer positiv beeinflusst.

Eine weitere Ausführungsform sieht vor, dass die elektrisch leitfähigen Verbindungsmittel parallel geschaltet und quer zu einer Stromrichtung angeordnet sind. Durch eine derartige Anordnung kann eine Symmetrierung der jeweiligen Strompfad-Impedanzen einfach und reproduzierbar erfolgen.

Eine weitere Ausführungsform sieht vor, dass die Halbleiteranordnung mindestens drei parallel geschaltete elektrisch leitfähige Verbindungsmittel umfasst, welche als Shunt-Widerstände und/oder dritte Bondverbindungsmittel ausgeführt sind. Derartige Verbindungsmittel sind kostengünstig und platzsparend zu implementieren. Es können bereits vorhandene Verbindungsmittel genutzt werden, um zusätzlichen Bauraum einzusparen.

Eine weitere Ausführungsform sieht vor, dass die Shunt-Widerstände und/oder dritten Bondverbindungsmittel stoffschlüssig mit der zweiten Leiterbahn und der dritten Leiterbahn des Substrats verbunden sind. Die stoffschlüssige Verbindung ist beispielsweise durch Löten oder Sintern herstellbar. Beim Drahtbonden ist eine stoffschlüssige Verbindung durch ein Reibschweiß-Verfahren herstellbar. Derartige Verbindungen sind zuverlässig und tragen damit zu einer hohen Lebensdauer der Halbleiteranordnung bei.

Eine weitere Ausführungsform sieht vor, dass die zweite Leiterbahn und die dritte Leiterbahn jeweils einen Messabgriff aufweisen, welche zur Erfassung eines Stroms durch die parallel geschalteten Shunt-Widerstände und/oder dritten Bondverbindungsmittel konfiguriert sind. Durch eine derartige Anordnung werden Kosten eingespart, da man auf ein zusätzliches Shunt-Modul verzichten kann.

Eine weitere Ausführungsform sieht vor, dass sich zumindest zwei elektrisch leitfähige Verbindungsmittel hinsichtlich ihrer Impedanz unterscheiden. Beispielsweise unterscheiden sich die zumindest zwei elektrisch leitfähige Verbindungsmittel hinsichtlich ihres Serienwiderstandes und/oder ihrer Induktivität. Beispielsweise wird bei einer komplexen Impedanz für die Berechnung eine Schaltfrequenz, bei welcher die Halbleiteranordnung betrieben wird, herangezogen. Durch die unterschiedlichen Impedanzen erfolgt eine Symmetrierung einfach und zuverläassig.

Eine weitere Ausführungsform sieht vor, dass sich die unterschiedlichen Impedanzen durch Werkstoffe mit unterschiedlicher elektrischer Leitfähigkeit und/oder durch eine unterschiedliche Leitergeometrie hergestellt sind. Durch Verwendung von Werkstoffen mit unterschiedlicher elektrischer Leitfähigkeit sind Verbindungsmittel mit identischer Geometrie verwendbar, was eine optimale Ausnutzung des vorhandenen Bauraums ermöglicht. Verbindungsmittel mit unterschiedliche Leitergeometrie, insbesondere Länge und/oder Querschnitt der Leiter, sind einfach und kostengünstig herstellbar.

Eine weitere Ausführungsform sieht vor, dass die zweite Leiterbahn über zumindest drei im Wesentlichen identisch ausgeführte elektrisch leitfähige Verbindungsmittel mit der dritten Leiterbahn des Substrats verbunden ist, wobei ein erstes elektrisch leitfähiges Verbindungsmittel einen ersten Abstand von einem zweiten elektrisch leitfähigen Verbindungsmittel aufweist, wobei das zweite elektrisch leitfähige Verbindungsmittel einen zweiten Abstand von einem dritten elektrisch leitfähigen Verbindungsmittel aufweist und wobei der zweite Abstand größer als der erste Abstand ist. Durch unterschiedliche Abstände erfolgt eine Symmetrierung einfach und kostengünstig. Insbesondere ist die Stromaufteilung, z.B. abhängig von einer Anwendung der Halbleiteranordnung, flexibel optimierbar.

Eine weitere Ausführungsform sieht vor, dass die Halbleiterelemente schräg und asymmetrisch auf dem Substrat verbunden sind. Durch eine derartige Anordnung wird eine Optimierung hinsichtlich einer Entwärmung durch Wärmespreizung und einer Stromaufteilung, z.B. durch Variation von Leitungslängen, welche parasitäre Impedanzen aufweisen, ermöglicht.

Eine weitere Ausführungsform sieht vor, dass die Halbleiterelemente Längskanten aufweisen, wobei sich die Abstände der jeweiligen Längskanten der Halbleiterelemente zur zweiten Leiterbahn hin vergrößern. Durch eine derartige Anordnung sind eine größere Wärmespreizung und eine verbesserte Strom-Symmetrierung, insbesondere Laststrom-Symmetrierung, erzielbar.

Eine weitere Ausführungsform sieht vor, dass die Halbleiterelemente parallel geschaltete Transistoren umfassen, wobei die Längskanten und/oder die ersten Bondverbindungsmittel des ersten Transistors mit den Längskanten und/oder ersten Bondverbindungsmitteln des zweiten Transistors einen ersten Winkel ausbilden, wobei die Längskanten und/oder die ersten Bondverbindungsmittel des dritten Transistors mit den Längskanten und/oder ersten Bondverbindungsmitteln des zweiten Transistors einen zweiten Winkel ausbilden. Durch eine derartige Anordnung sind eine größere Wärmespreizung und eine verbesserte Strom-Symmetrierung, insbesondere Laststrom-Symmetrierung, erzielbar.

Eine weitere Ausführungsform sieht vor, dass sich der erste Winkel vom zweiten Winkel unterscheidet. Die Winkel unterscheiden sich insbesondere in ihrem Betrag. Durch eine derartige Anordnung sind eine größere Wärmespreizung und eine verbesserte Strom-Symmetrierung, insbesondere Laststrom-Symmetrierung, erzielbar.

Im Folgenden wird die Erfindung anhand der in den Figuren dargestellten Ausführungsbeispiele näher beschrieben und erläutert. Es zeigen
- FIG 1: eine schematische Darstellung einer ersten Ausführungsform einer Halbleiteranordnung in einer Draufsicht,
- FIG 2: eine schematische Darstellung einer ersten Ausführungsform einer Halbleiteranordnung in einem Längsschnitt,
- FIG 3: ein vereinfachtes Schaltbild einer ersten Ausführungsform einer Halbleiteranordnung,
- FIG 4: eine schematische Darstellung einer zweiten Ausführungsform einer Halbleiteranordnung in einer Draufsicht,
- FIG 5: eine schematische Darstellung einer dritten Ausführungsform einer Halbleiteranordnung in einer Draufsicht und

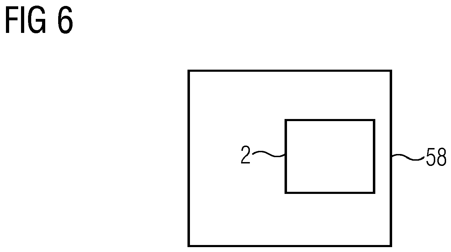

- FIG 6: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

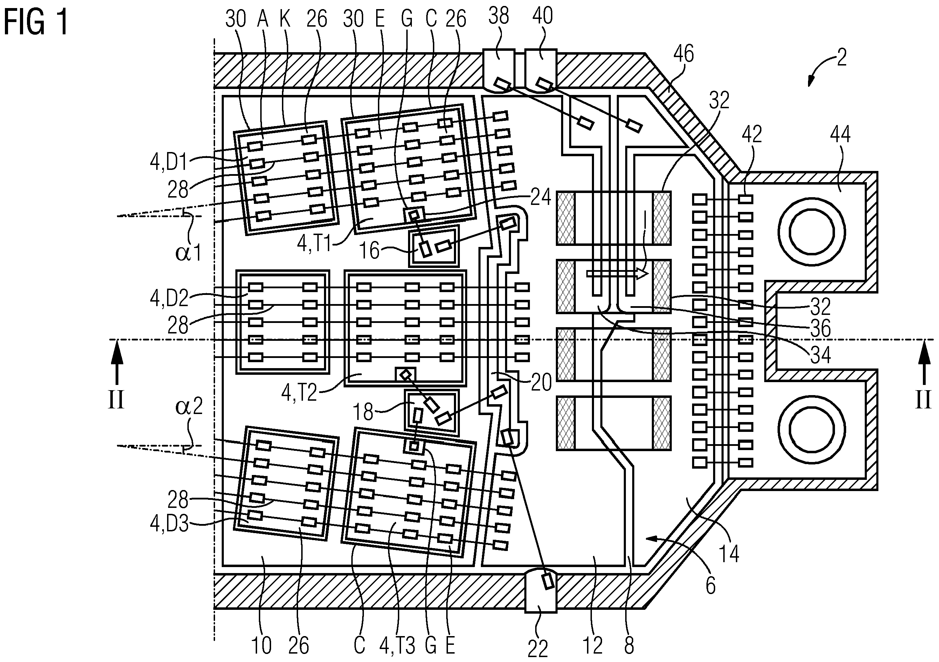

FIG 1 zeigt eine schematische Darstellung einer ersten Ausführungsform einer Halbleiteranordnung 2 in einer Draufsicht, welche Halbleiterelemente 4 umfasst, die auf einem isolierenden Substrat 6 kontaktiert sind. Die Halbleiterelemente 4 umfassen Transistoren T1, T2, T3 mit antiparallelen Dioden D1, D2, D3, wobei die Halbleiterelemente 4 parallel geschaltet sind. Die Transistoren T1, T2, T3 sind exemplarisch als Insulated-Gate-Bipolar-Transistoren (IGBTs) ausgeführt. Alternativ können die Transistoren T1, T2, T3 als andere Transistortypen wie Feldeffekttransistoren oder Bipolartransistoren ausgeführt sein. Die Transistoren T1, T2, T3 weisen jeweils einen Steueranschluss, der als Gate-Anschluss G ausgeführt ist, sowie Lastanschlüsse, die als KollektorAnschluss C und Emitter-Anschluss E ausgeführt sind, auf. Die Dioden D1, D2, D3 weisen jeweils Lastanschlüsse aus, die als Anode A und Kathode K ausgeführt sind.

Das Substrat 6 umfasst eine dielektrische Materiallage 8, die beispielsweise einen keramischen Werkstoff, insbesondere Aluminiumnitrid oder Aluminiumoxid, enthält. Auf der dielektrischen Materiallage 8 sind elektrisch voneinander isolierte Leiterbahnen 10, 12, 14, 16, 18, 20 angeordnet. Die Kollektor-Anschlüsse C der Transistoren T1, T2, T3 und die Kathoden K der Dioden D1, D2, D3 sind stoffschlüssig mit einer ersten Leiterbahn 10 des Substrats 6 verbunden. Die stoffschlüssige Verbindung ist beispielsweise durch Löten oder Sintern hergestellt. Die Gate-Anschlüsse G weisen metallische Steuerkontaktflächen 24 auf, welche über Gate-Leiterbahnen 16, 18 20 mit einer Gate-Elektrode 22 verdrahtet sind. Die Emitter-Anschlüsse E sowie die Anoden A weisen metallische Kontaktflächen 26 auf, welche über, beispielhaft fünf, erste Bondverbindungsmittel 28 mit einer zweiten Leiterbahn 12 verbunden sind. Die ersten Bondverbindungsmittel 28 der jeweiligen Transistoren T1, T2, T3 und antiparallelen Dioden D1, D2, D3, welche beispielsweise als Bonddrähte oder Bondbänder ausgeführt sind, sind im Wesentlichen parallel zueinander angeordnet.

Die Halbleiterelemente 4 sind schräg und asymmetrisch auf der ersten Leiterbahn 10 angeordnet, wobei sich die Abstände der jeweiligen Längskanten 30 der Halbleiterelemente 4 zur zweiten Leiterbahn 12 hin vergrößern. Insbesondere sind die jeweiligen ersten Bondverbindungsmittel 28 parallel zu den Längskanten 30 angeordnet. Die Längskanten 30 und/oder die ersten Bondverbindungsmittel 28 des ersten Transistors T1 bilden mit den Längskanten 30 und/oder ersten Bondverbindungsmitteln 28 des zweiten Transistors T2 einen ersten Winkel α1 aus. Die Längskanten 30 und/oder die ersten Bondverbindungsmittel 28 des dritten Transistors T3 bilden mit den Längskanten 30 und/oder ersten Bondverbindungsmitteln 28 des zweiten Transistors T2 einen zweiten Winkel α2 aus. Insbesondere unterscheidet sich der erste Winkel α1 vom zweiten Winkel α2. Durch eine derartige Anordnung wird eine maximale Wärmespreizung auf dem Substrat 6 erreicht.

Die zweite Leiterbahn 12 ist über elektrisch leitfähige Verbindungsmittel 32 mit der dritten Leiterbahn 14 des Substrats 6 verbunden. Die elektrisch leitfähigen Verbindungsmittel 32 in FIG 1 sind beispielhaft als parallel geschaltete Shunt-Widerstände ausgeführt. Die Shunt-Widerstände sind quer zu einer Stromrichtung angeordnet. Die zweite Leiterbahn 12 und die dritte Leiterbahn 14 weisen jeweils einen Messabgriff 34, 36 auf. Die Messabgriffe 34, 36 sind zur Erfassung eines Stroms durch die parallel geschalteten Shunt-Widerstände konfiguriert und mit Messelektroden 38, 40 verdrahtet. Die Messabgriffe 34, 36 liegen bevorzugt an einer Position, die immer mit einem Bauteil, insbesondere Shunt-Widerstand, bestückt ist, welches einem Zielwert für die Messung entspricht. Somit kann eine zuverlässige und genaue Messung gesichert werden. Bei einer geraden Anzahl an möglichen Positionen sind die Messabgriffe 34, 36 jeweils auf zwei Bauteile aufteilbar. Über zweite Bondverbindungsmittel 42 ist die dritte Leiterbahn 14 mit einem Anschlusselement 44 verbunden.

Die Transistoren T1, T2, T3 mit den antiparallel geschalteten Dioden D1, D2, D3 bilden jeweils einen Strompfad mit einer Strompfad-Impedanz zum Anschlusselement 44 aus. Drei unterschiedliche Strompfade können sich unter anderem durch die in FIG 1 dargestellten drei parallel geschalteten Transistoren T1, T2, T3 und/oder durch unterschiedliche Schaltzustände ausbilden. Die Strompfad-Impedanz kann sich aus den jeweiligen Impedanzen, insbesondere Widerstände, der Halbleiterelemente 4, der Bondverbindungsmittel 28, 42 im Strompfad, der Leiterbahnen 10, 12, 14 auf dem Substrat 6, der Shunt-Widerstände und Übergängen, z.B. zum Anschlusselement 44, zusammensetzen. Durch eine unterschiedliche Dimensionierung der elektrisch leitfähigen Verbindungsmittel 32 werden Strompfad-Impedanzen der jeweiligen Strompfade ausgeglichen. In FIG 1 unterscheiden sich die zumindest zwei elektrisch leitfähige Verbindungsmittel 32 hinsichtlich ihres Serienwiderstandes. Unterschiedliche Serienwiderstände werden durch Verwendung von Werkstoffen mit unterschiedlicher elektrischer Leitfähigkeit und/oder durch eine unterschiedliche Leitergeometrie, insbesondere Länge und/oder Querschnitt des Leiters, hergestellt. Somit wird der Gesamtwiderstand der jeweiligen Strompfade symmetriert, was zu einer gleichmäßigen Erwärmung der Halbleiterelemente 4, insbesondere Transistoren T1, T2, T3, führt. Die Halbleiterelemente 4 und das Substrat 6 sind in einem Gehäuse 46, insbesondere Kunststoffgehäuse, angeordnet.

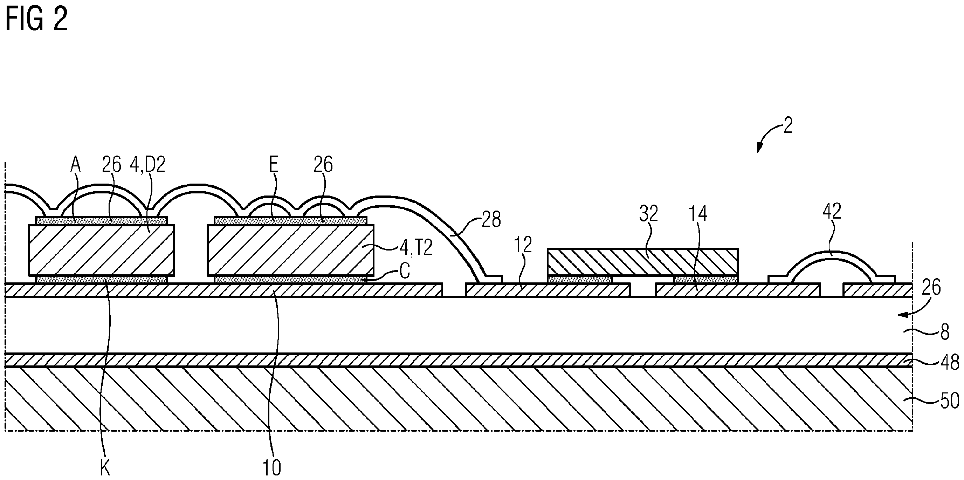

FIG 2 zeigt eine schematische Darstellung einer ersten Ausführungsform einer Halbleiteranordnung 2 in einem Längsschnitt. Das Substrat ist über eine durchgängige Metallisierung 48, insbesondere stoffschlüssig, z.B. durch eine Löt- oder Sinterverbindung, mit einem Kühlkörper 50 verbunden. Die weitere Ausführung der Halbleiteranordnung 2 in FIG 2 entspricht der in FIG 1.

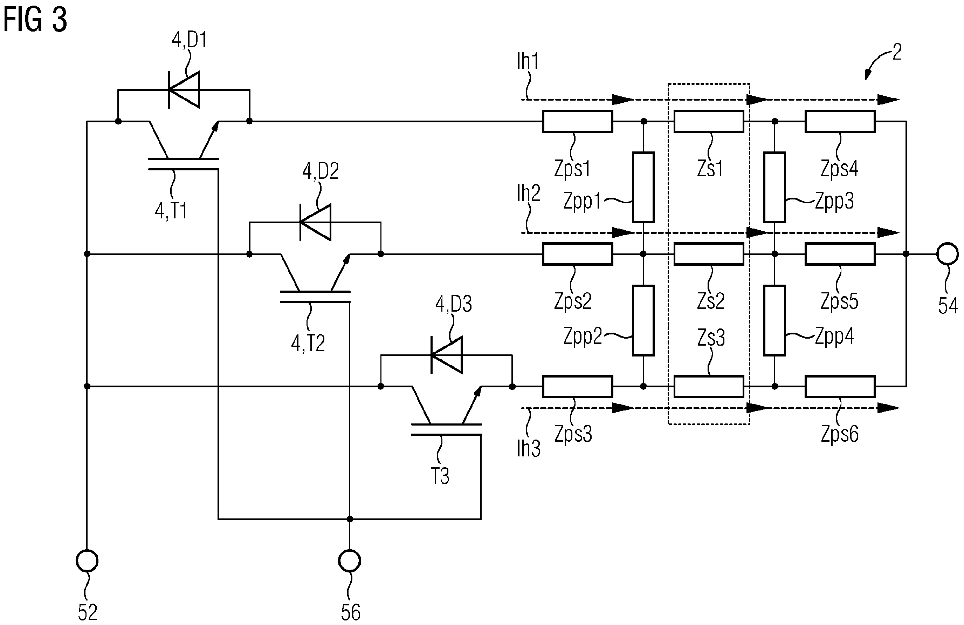

FIG 3 zeigt ein vereinfachtes Schaltbild einer ersten Ausführungsform einer Halbleiteranordnung 2. Die Transistoren T1, T2, T3 sind kollektorseitig mit einem ersten Lastanschluss 52 und emitterseitig mit einem zweiten Lastanschluss 54 verbunden, während die Gates mit einem Steueranschluss 56 verbunden sind. Die Transistoren T1, T2, T3 bilden jeweils einen Hauptstrompfad Ih1, Ih2, Ih3 aus. Die Hauptstrompfade Ih1, Ih2, Ih3 weisen jeweils eine Shunt-Widerstand-Impedanz Zs1, Zs2, Zs3 auf, welche von der Dimensionierung der jeweiligen Shunt-Widerstände und deren Anordnung abhängen. Ferner sind jeweils parasitäre Serien-Impedanzen Zps1, Zps2, Zps3 und Parallel-Impedanzen Zpp1, Zpp2 vor den Shunt-Widerständen und parasitäre Serien-Impedanzen Zps4, Zps5, Zps6 und Parallel-Impedanzen Zpp3, Zpp4 hinter den Shunt-Widerständen ausgebildet, die insbesondere aufbau- und geometrieabhängig sind. Durch eine unterschiedliche Dimensionierung der Shunt-Widerstand-Impedanzen Zs1, Zs2, Zs3 werden die Impedanzen der Hauptstrompfade Ih1, Ih2, Ih3 ausgeglichen, was zu einer gleichmäßigen Erwärmung der Halbleiterelemente 4, insbesondere Transistoren T1, T2, T3, führt

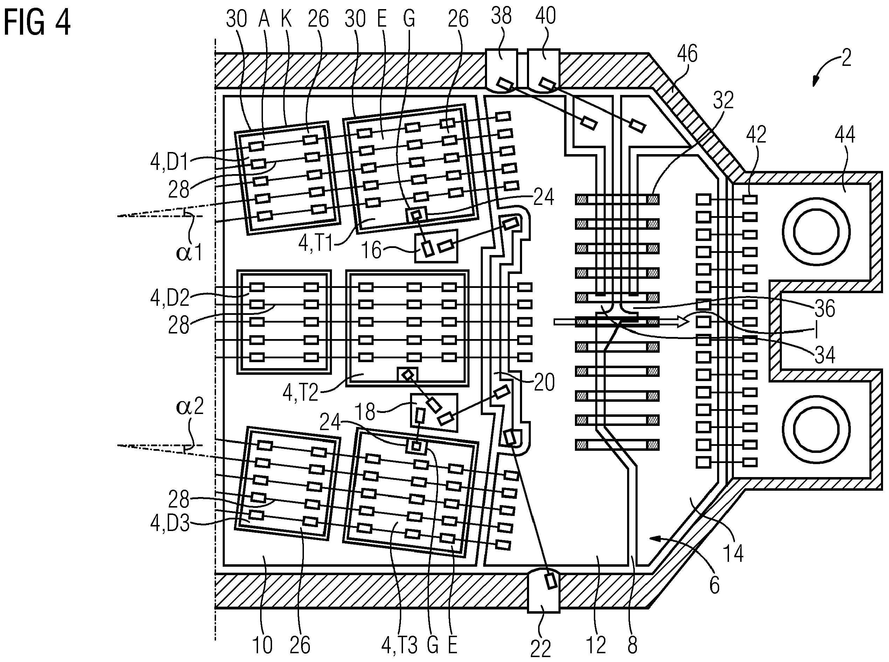

FIG 4 zeigt eine schematische Darstellung einer zweiten Ausführungsform einer Halbleiteranordnung 2 in einer Draufsicht. Die elektrisch leitfähigen Verbindungsmittel 32 sind als Bondverbindungsmittel, insbesondere als Bonddrähte oder Bondbänder, ausgeführt. Die zumindest zwei Bondverbindungsmittel unterscheiden sich hinsichtlich ihrer Impedanz, insbesondere Serienimpedanz. Die unterschiedlichen Impedanzen werden durch Verwendung von Werkstoffen, insbesondere Legierungen, mit unterschiedlicher elektrischer Leitfähigkeit und/oder durch eine unterschiedliche Leitergeometrie hergestellt. Die Leitergeometrie wird durch eine unterschiedliche Länge und/oder durch einen unterschiedlichen Querschnitt der Bondverbindungsmittel variiert. Die weitere Ausführung der Halbleiteranordnung 2 in FIG 4 entspricht der in FIG 1.

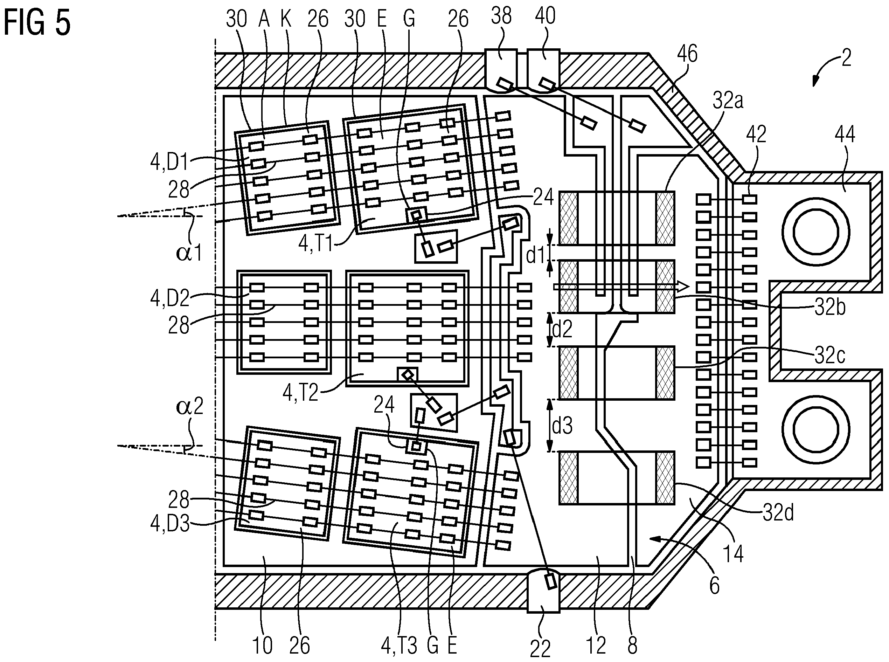

FIG 5 zeigt eine schematische Darstellung einer dritten Ausführungsform einer Halbleiteranordnung 2 in einer Draufsicht. Beispielsweise sind elektrisch leitfähige Verbindungsmittel 32a, 32b, 32c, 32d als im Wesentlichen identisch ausgeführte Shunt-Widerstände ausgeführt, welche derartig angeordnet sind, dass die Strompfad-Impedanzen der jeweiligen Strompfade im Wesentlichen ausgeglichen sind. Ein erstes elektrisch leitfähiges Verbindungsmittel 32a weist einen ersten Abstand d1 von einem zweiten elektrisch leitfähigen Verbindungsmittel 32b auf, wobei das zweite elektrisch leitfähige Verbindungsmittel 32b einen zweiten Abstand d2 von einem dritten elektrisch leitfähigen Verbindungsmittel 32d aufweist und wobei das dritte elektrisch leitfähige Verbindungsmittel 32c einen dritten Abstand d3 von einem vierten elektrisch leitfähigen Verbindungsmittel 32d aufweist. Die Abstände d1, d2, d3 unterscheiden sich voneinander. Beispielhaft ist der erste Abstand d1 kleiner als der zweite Abstand d2 und der zweite Abstand d2 ist kleiner als der dritte Abstand d3. Diese Abstände bewirken, dass eine Strompfad-Impedanz durch die Anordnung der Shunt-Widerstände im Bereich des ersten Transistors T1 im Vergleich zur Impedanz im Bereich des zweiten und dritten Transistors T2, T3 reduziert wird. Durch eine derartige Anordnung ist unter anderem eine erhöhte Verdrahtungsimpedanz und/oder Zuleitungsimpedanz des ersten Transistors T1 ausgleichbar, sodass ein Gesamtwiderstand der jeweiligen Strompfade symmetriert wird.

FIG 10 zeigt eine schematische Darstellung eines Stromrichters 58, welcher beispielhaft eine Halbleiteranordnung 2 umfasst.

Zusammenfassend betrifft die Erfindung eine Halbleiteranordnung 2 mit mindestens zwei, insbesondere parallel geschalteten, Halbleiterelementen 4, einem isolierenden Substrat 6 und einem Anschlusselement 44, wobei das Substrat 6 elektrisch voneinander isolierte Leiterbahnen 10, 12, 14 aufweist, wobei die Halbleiterelemente 4, insbesondere stoffschlüssig, mit einer ersten Leiterbahn 10 des Substrats 6 verbunden sind und auf einer dem Substrat 6 abgewandten Seite jeweils zumindest eine Kontaktfläche 26 aufweisen, wobei jeweils zumindest eine Kontaktfläche 26 der Halbleiterelemente 4 über erste Bondverbindungsmittel 28 mit der zweiten Leiterbahn 12 des Substrats 6 verbunden ist, wobei die zweite Leiterbahn 12 über elektrisch leitfähige Verbindungsmittel 32, 32a, 32b, 32c, 32d mit einer dritten Leiterbahn 14 des Substrats 6 verbunden ist, wobei die dritte Leiterbahn 14 mit dem Anschlusselement 44 verbunden ist, wobei von den Halbleiterelementen 4 zum Anschlusselement 44 jeweils ein Strompfad mit einer Strompfad-Impedanz ausgebildet ist. Um eine höhere Lebensdauer zu erreichen und Kosten zu sparen, wird vorgeschlagen, dass die elektrisch leitfähigen Verbindungsmittel 32, 32a, 32b, 32c, 32d derartig dimensioniert und/oder angeordnet sind, dass die Strompfad-Impedanzen der jeweiligen Strompfade im Wesentlichen ausgeglichen sind.

## Patentansprüche

1. Halbleiteranordnung (2) mit mindestens zwei, insbesondere parallel geschalteten, Halbleiterelementen (4), einem isolierenden Substrat (6) und einem Anschlusselement (44),
wobei das Substrat (6) elektrisch voneinander isolierte Leiterbahnen (10, 12, 14) aufweist,
wobei die Halbleiterelemente (4), insbesondere stoffschlüssig, mit einer ersten Leiterbahn (10) des Substrats (6) verbunden sind und
auf einer dem Substrat (6) abgewandten Seite jeweils zumindest eine Kontaktfläche (26) aufweisen,
wobei jeweils zumindest eine Kontaktfläche (26) der Halbleiterelemente (4) über erste Bondverbindungsmittel (28) mit einer zweiten Leiterbahn (12) des Substrats (6) verbunden ist, wobei die zweite Leiterbahn (12) über elektrisch leitfähige Verbindungsmittel (32, 32a, 32b, 32c, 32d) mit einer dritten Leiterbahn (14) des Substrats (6) verbunden ist,
wobei die dritte Leiterbahn (14) mit dem Anschlusselement (44) verbunden ist,
wobei von den Halbleiterelementen (4) zum Anschlusselement (44) jeweils ein Strompfad mit einer Strompfad-Impedanz ausgebildet ist,
**dadurch gekennzeichnet, dass**
die elektrisch leitfähigen Verbindungsmittel (32, 32a, 32b, 32c, 32d) derartig dimensioniert und/oder angeordnet sind, dass die Strompfad-Impedanzen der jeweiligen Strompfade im Wesentlichen ausgeglichen sind.

2. Halbleiteranordnung (2) nach Anspruch 1,
wobei die elektrisch leitfähigen Verbindungsmittel (32, 32a, 32b, 32c, 32d) parallel geschaltet und quer zu einer Stromrichtung (I) angeordnet sind.

3. Halbleiteranordnung (2) nach einem der Ansprüche 1 oder 2, umfassend mindestens drei parallel geschaltete elektrisch leitfähige Verbindungsmittel (32, 32a, 32b, 32c, 32d), welche als Shunt-Widerstände und/oder dritte Bondverbindungsmittel ausgeführt sind.

4. Halbleiteranordnung (2) nach Anspruch 3,
wobei die Shunt-Widerstände und/oder dritten Bondverbindungsmittel stoffschlüssig mit der zweiten Leiterbahn (12) und der dritten Leiterbahn (14) des Substrats (6) verbunden sind.

5. Halbleiteranordnung (2) nach einem der Ansprüche 2 bis 4, wobei die zweite Leiterbahn (12) und die dritte Leiterbahn (14) jeweils einen Messabgriff (34, 36) aufweisen, welche zur Erfassung eines Stroms durch die parallel geschalteten Shunt-Widerstände und/oder dritten Bondverbindungsmittel konfiguriert sind.

6. Halbleiteranordnung (2) nach einem der vorherigen Ansprüche,
wobei sich zumindest zwei elektrisch leitfähige Verbindungsmittel (32, 32a, 32b, 32c, 32d) hinsichtlich ihrer Impedanz unterscheiden.

7. Halbleiteranordnung (2) nach Anspruch 6,
wobei die unterschiedlichen Impedanzen durch Werkstoffe mit unterschiedlicher elektrischer Leitfähigkeit und/oder durch eine unterschiedliche Leitergeometrie hergestellt sind.

8. Halbleiteranordnung (2) nach einem der vorherigen Ansprüche,
wobei die zweite Leiterbahn (12) über zumindest drei im Wesentlichen identisch ausgeführte elektrisch leitfähige Verbindungsmittel (32, 32a, 32b, 32c, 32d) mit der dritten Leiterbahn (14) des Substrats (6) verbunden ist,
wobei ein erstes elektrisch leitfähiges Verbindungsmittel (32a) einen ersten Abstand (d1) von einem zweiten elektrisch leitfähigen Verbindungsmittel (32b) aufweist, wobei das zweite elektrisch leitfähige Verbindungsmittel (32b) einen zweiten Abstand (d2) von einem dritten elektrisch leitfähigen Verbindungsmittel (32c) aufweist und wobei der zweite Abstand (d2) größer als der erste Abstand (d1) ist.

9. Halbleiteranordnung (2) nach einem der vorherigen Ansprüche,
wobei die Halbleiterelemente (4) schräg und asymmetrisch auf dem Substrat (6) verbunden sind.

10. Halbleiteranordnung (2) nach Anspruch 9,
wobei die Halbleiterelemente (4) Längskanten (30) aufweisen, wobei sich die Abstände der jeweiligen Längskanten (30) der Halbleiterelemente (4) zur zweiten Leiterbahn (12) hin vergrößern.

11. Halbleiteranordnung (2) nach einem der Ansprüche 9 oder 10,
wobei die Halbleiterelemente (4) parallel geschaltete Transistoren (T1, T2, T3) umfassen,
wobei die Längskanten (30) und/oder die ersten Bondverbindungsmittel (28) des ersten Transistors (T1) mit den Längskanten (30) und/oder ersten Bondverbindungsmitteln (28) des zweiten Transistors (T2) einen ersten Winkel (α1) ausbilden, wobei die Längskanten (30) und/oder die ersten Bondverbindungsmittel (28) des dritten Transistors (T3) mit den Längskanten (30) und/oder ersten Bondverbindungsmitteln (28) des zweiten Transistors (T2) einen zweiten Winkel (α2) ausbilden.

12. Halbleiteranordnung (2) nach Anspruch 11,
wobei sich der erste Winkel (α1) vom zweiten Winkel (α2) unterscheidet.

13. Halbleitermodul mit mindestens einer Halbleiteranordnung (2) nach einem der vorherigen Ansprüche.

14. Stromrichter (58) mit mindestens einer Halbleiteranordnung (2) nach einem der vorherigen Ansprüche.

15. Verfahren zur Herstellung einer Halbleiteranordnung (2) mit mindestens zwei, insbesondere parallel geschalteten, Halbleiterelementen (4), einem isolierenden Substrat (6) und einem Anschlusselement (44),
wobei das Substrat (6) elektrisch voneinander isolierte Leiterbahnen (10, 12, 14) aufweist,
wobei die Halbleiterelemente (4), insbesondere stoffschlüssig, mit einer ersten Leiterbahn (10) des Substrats (6) verbunden werden und
auf einer dem Substrat (6) abgewandten Seite jeweils zumindest eine Kontaktfläche (26) aufweisen,
wobei jeweils zumindest eine Kontaktfläche (26) der Halbleiterelemente (4) über erste Bondverbindungsmittel (28) mit einer zweiten Leiterbahn (12) des Substrats (6) verbunden wird, wobei die zweite Leiterbahn (12) über elektrisch leitfähige Verbindungsmittel (32, 32a, 32b, 32c, 32d) mit einer dritten Leiterbahn (14) des Substrats (6) verbunden wird,
wobei die dritte Leiterbahn (14) mit dem Anschlusselement (44) verbunden wird,
wobei von den Halbleiterelementen (4) zum Anschlusselement (44) jeweils ein Strompfad mit einer Strompfad-Impedanz ausgebildet ist,
**dadurch gekennzeichnet, dass**
die elektrisch leitfähigen Verbindungsmittel (32, 32a, 32b, 32c, 32d) derartig dimensioniert und/oder angeordnet werden, dass die Strompfad-Impedanzen der jeweiligen Strompfade im Wesentlichen ausgeglichen sind.
